Europäisches Patentamt

European Patent Office

Office européen des brevets

(11) Numéro de publication : **0 023 180**
**B1**

(12) **FASCICULE DE BREVET EUROPÉEN**

(45) Date de publication du fascicule du brevet :
**18.01.84**

(21) Numéro de dépôt : **80401075.9**

(22) Date de dépôt : **18.07.80**

(51) Int. Cl.³ : **G 01 R 15/07**

(54) **Dispositif interférométrique de mesure de courant électrique à fibre optique.**

(30) Priorité : **24.07.79 FR 7919078**

(43) Date de publication de la demande :
**28.01.81 Bulletin 81/04**

(45) Mention de la délivrance du brevet :
**18.01.84 Bulletin 84/03**

(84) Etats contractants désignés :
**DE GB IT NL SE**

(56) Documents cités :
**DE-B- 2 433 432**
**FR-E-    92 558**
**GB-A- 1 258 172**
**US-A- 3 102 953**
**US-A- 3 778 619**

(73) Titulaire : **THOMSON-CSF**
**173, Boulevard Haussmann**
**F-75379 Paris Cedex 08 (FR)**

(72) Inventeur : **Puech, Claude**
**THOMSON-CSF SCPI 173, Bld Haussmann**
**F-75360 Paris Cedex 08 (FR)**
Inventeur : **Arditty, Hervé**
**THOMSON-CSF SCPI 173, Bld Haussmann**
**F-75360 Paris Cedex 08 (FR)**
Inventeur : **Papuchon, Michel**
**"THOMSON-CSF SCPI 173, Bld Haussmann**
**F-75360 Paris Cedex 08 (FR)**

(74) Mandataire : **Wang, Pierre et al**
**THOMSON-CSF SCPI 173, Bld Haussmann**
**F-75379 Paris Cedex 08 (FR)**

Jouve, 18, rue St-Denis, 75001 Paris, France

Dispositif interférométrique de mesure de courant électrique à fibre optique

L'invention se rapporte au domaine de la mesure des courants électriques et a plus particulièrement pour objet un dispositif de mesure de tels courants ayant une grande gamme de mesure et susceptible de fonctionner convenablement dans un environnement difficile.

La mesure de courants continus ayant de fortes intensités est difficile avec les dispositifs de mesure habituels, dans certains environnements, particulièrement dans les centrales électriques ou les usines d'électrochimie. En effet, dans de tels environnements, les fortes tensions, les températures élevées, l'atmosphère éventuellement corrosive, la pollution électromagnétique ou tout simplement l'accessibilité difficile rendent les mesures difficiles et peu fiables lorsqu'elles sont effectuées par des moyens classiques du type shunt ou jauge à effet Hall par exemple. Ainsi, pour mesurer des courants de l'ordre d'une centaine de milliers d'ampères, les dispositifs de mesure de courant type shunt ne permettent d'obtenir qu'une précision de l'ordre de 10 % de la valeur mesurée. De plus, de tels dispositifs entraînent des pertes d'énergie dans le dispositif de mesure.

L'invention propose un dispositif de mesure de courants électriques ayant une grande gamme de mesure, précis et très sensible qui, lorsque l'environnement est difficile peut être disposé de façon que la partie mesure du dispositif soit située dans un endroit éventuellement protégé, la partie capteur étant seule placée dans l'environnement et étant insensible aux conditions imposées par cet environnement. De plus, ce dispositif de mesure est sans contact avec le circuit principal dans lequel circule le courant à mesurer, ce qui permet de ne pas avoir de pertes dans le circuit principal occasionnées par le dispositif de mesure. Ce dispositif de mesure a donc un excellent découplage électrique.

Pour ce faire, l'effet magnétooptique qui se manifeste par exemple dans les dispositifs décrits dans US-A-3 778 619, FR-E-92 558 et DE-B-24 334 32 est mis à profit. Comme il est connu, lorsqu'une onde lumineuse se propage parallèlement aux lignes de force d'un champ magnétique, celui-ci induit sur l'onde un effet non réciproque appelé effet Faraday.

Plus particulièrement le dispositif de mesure de l'invention mettra en œuvre les éléments principaux d'un interféromètre à fibre optique enroulée pour guider une onde lumineuse. Un tel dispositif est décrit, par exemple, dans les documents US-A-3 102 953 (figure 2) et GB-A-1 258 172. Dans l'invention l'onde ainsi guidée sera perturbée par le courant à mesurer, au lieu d'être influencée par la rotation de la boucle de fibre.

L'invention a donc pour objet un dispositif interférométrique de mesure de courant électrique à fibre optique caractérisé en ce qu'il comporte une fibre optique enroulée formant au moins une spire autour d'un conducteur dans lequel circule le courant I à mesurer, et en ce que les deux extrémités de cette fibre optique sont couplées à une source de lumière par un dispositif optique comportant des moyens de séparation du faisceau issu de la source en deux ondes destinées à circuler dans la fibre en sens contraires, le dispositif optique comportant également des moyens de recombinaison des ondes émergeant de la fibre et un dispositif de détection fournissant un signal correspondant aux interférences entre les deux ondes émergeant de la fibre, le signal issu du dispositif de détection étant lié au déphasage $\Delta\Phi_1$ entre les deux ondes circulant en sens contraires, ce déphasage étant induit par le courant I par effet Faraday dans la fibre, le dispositif de mesure comportant en outre un dispositif de traitement de signal couplé au dispositif de détection et fournissant à partir du signal issu du dispositif de détection, un signal lié au déphasage $\Delta\Phi_1$.

L'invention sera mieux comprise et d'autres caractéristiques apparaîtront à l'aide de la description qui suit en référence aux figures annexées.

La figure 1 représente un premier mode de réalisation du dispositif de mesure de courant suivant l'invention.

La figure 2 représente une courbe montrant les variations d'intensité lumineuse sur le détecteur en fonction du déphasage induit, dans la fibre optique, par le conducteur électrique.

La figure 3 représente un second mode de réalisation du dispositif de mesure suivant l'invention mettant en œuvre une méthode de zéro.

La figure 4 représente un troisième mode de réalisation du dispositif de mesure suivant l'invention dans lequel le courant de référence est modulé.

La figure 5 représente un autre mode de réalisation du dispositif suivant l'invention, partiellement réalisé en optique intégrée, dans lequel l'onde optique est affectée d'un déphasage modulé.

Les figures 6 et 7 représentent deux modes de réalisation de capteurs susceptibles d'être mis en œuvre dans les dispositifs de mesure suivant l'invention à méthode de zéro, également utilisables comme éléments de liaison vers la partie mesure du dispositif.

La figure 8 schématise la dissociation possible, dans une implantation, entre la partie capteur et la partie mesure du dispositif.

Le courant circulant dans un conducteur induit un champ magnétique autour de ce conducteur. Si une onde lumineuse se propage dans un milieu entourant ce conducteur, le champ magnétique induit, par effet magnétooptique, des variations dans les conditions de propagation de l'onde lumineuse. Lorsque le champ magnétique et la direction de propagation de l'onde lumineuse sont parallèles, l'effet magnétooptique induit sur l'onde lumineuse est un effet non réciproque, appelé effet Faraday, dépendant du sens de propagation de l'onde par rapport au sens du champ magnétique.

Pour mettre en évidence par cet effet non réciproque une quantité mesurable qui soit directement liée au courant circulant dans le conducteur, et qui par conséquent n'intègre pas d'autres effets et en particulier les effets réciproques produisant eux aussi des variations dans les conditions de propagation, (variation de température ou variation de pression par exemple), le dispositif suivant l'invention utilise deux ondes contrarotatives dans le même milieu de propagation entourant le conducteur ; ces deux ondes subissent de la même manière les effets réciproques induisant dans le milieu des variations dans les conditions de propagation variant dans le même sens, et subissent par effet Faraday non réciproque des variations en sens contraires. Ces variations en sens contraires sont susceptibles d'être détectées par une méthode interférométrique.

Pour cela, le dispositif de mesure de courant suivant l'invention comporte une fibre optique enroulée autour du conducteur dans lequel circule le courant I à mesurer, cette fibre optique comportant une ou plusieurs spires, les deux extrémités de cette fibre optique enroulée recevant chacune une onde optique issue par exemple d'un laser ; ces deux ondes circulent en sens contraires dans la fibre. Le courant circulant dans le conducteur induit un champ magnétique dans le même sens que le sens de propagation de l'une des ondes et en sens contraire de l'autre. Les deux ondes émergeant de la fibre présentent un déphasage $\Delta\Phi$ qui dépend de la constante de Verdet caractéristique de l'effet Faraday du milieu de propagation, de l'intensité I du courant circulant dans le conducteur, (éventuellement du nombre N de conducteurs lorsque la fibre optique entoure plusieurs branches de conducteur dans lequel circule le même courant I), et du nombre M de tours de la fibre optique entourant le conducteur.

Pour mettre en évidence le déphasage entre les deux ondes, le dispositif de mesure suivant l'invention met en œuvre une structure d'interféromètre, les deux ondes contrarotatives émergeant des extrémités de la fibre étant recombinées et le signal correspondant étant détecté par un photodétecteur.

Compte tenu des différentes constantes intervenant dans le dispositif, et des variations dans le temps susceptibles de se produire, il est très difficile de connaître le facteur d'échelle d'un tel dispositif de mesure, c'est à dire la relation liant l'intensité I du courant circulant dans le conducteur et l'intensité lumineuse L détectée sur le photodétecteur. En conséquence, dans les modes de réalisation préférés de l'invention, le dispositif de mesure met en œuvre une méthode de zéro pour effectuer cette mesure. Pour cela la fibre optique, et donc l'onde optique, subissent les effets d'un champ magnétique de référence produit par un courant i très inférieur au courant à mesurer parcourant un conducteur passant un grand nombre de fois par la boucle de fibre optique. Le courant i est réglable et ajusté à tout moment pour compenser le déphasage $\Delta\Phi$ induit par le courant I en créant un déphasage $-\Delta\Phi$ induit par le courant i.

Les explications données ci-dessus permettent de mieux comprendre les différents modes de réalisation du dispositif de mesure de courant décrit ci-après en référence aux figures annexées.

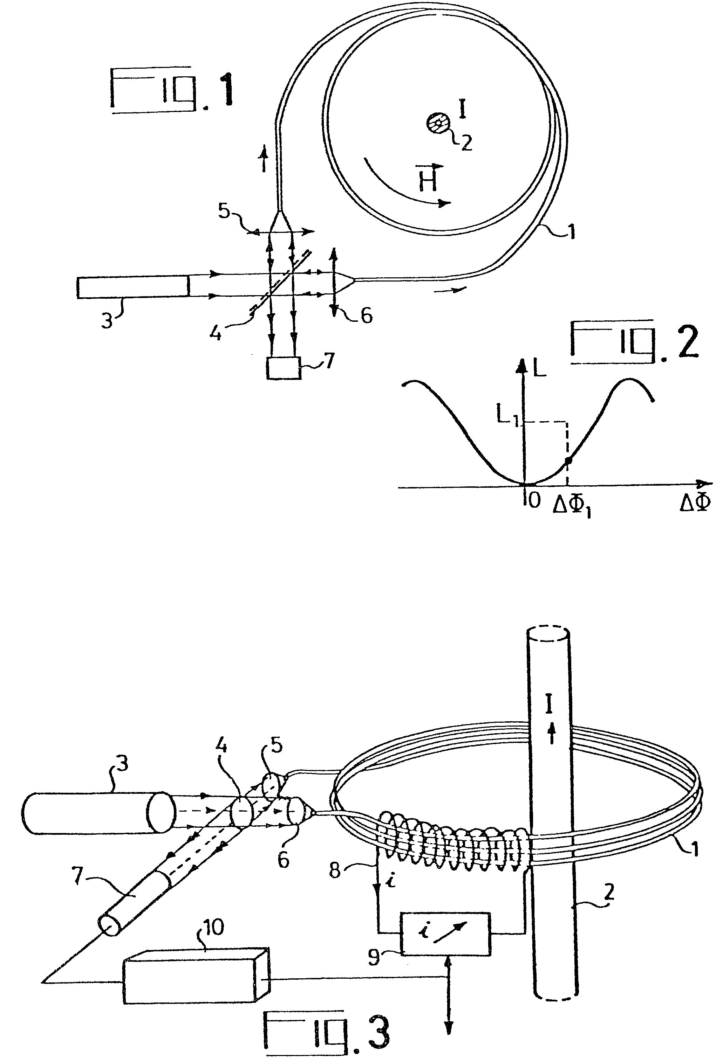

La figure 1 représente le mode de réalisation le plus simple du dispositif de mesure de courant suivant l'invention. Il comporte une fibre optique 1, monomode ou multimode, enroulée autour du conducteur 2 dans lequel circule le courant I à mesurer.

Cette fibre forme une ou plusieurs spires autour du conducteur, suivant la gamme de courant à mesurer. Un faisceau lumineux issu d'un laser 3 est couplé simultanément aux deux extrémités de la fibre 1 par l'intermédiaire d'un circuit optique de séparation et de couplage comportant un séparateur de faisceau 4 et des lentilles 5 et 6 focalisant le rayonnement qui les traverse sur les faces des extrémités de la fibre. Les deux ondes lumineuses circulent dans la fibre en ses contraires, émergent par les deux extrémités et traversent les lentilles respectivement 6 et 5 pour se recombiner après, respectivement, réflexion et transmission par le séparateur de faisceau 4. Le rayonnement résultant du mélange des ondes émergentes est détecté par un photodétecteur 7. Lorsque le conducteur 2 est parcouru par un courant I, il induit un champ magnétique H suivant des lignes fermées autour de ce conducteur. L'onde lumineuse se propageant dans la fibre subit, sur ses composantes de polarisation circulaire, un déphasage induit par effet Faraday par le champ magnétique. On sait qu'une fibre optique se comporte comme un empilement de lames biréfringentes quelconques induisant sur l'onde lumineuse qui se propage des variations de polarisation. Ces effets sont réciproques et agissent sur les deux ondes contrarotatives de la même manière ; par contre l'effet de polarisation rotatoire magnétique agissant seulement sur les ondes de polarisation circulaire pour introduire une avance ou un retard sur chacune des composantes, agit dans des sens différents sur les deux ondes contrarotatives et introduit donc entre elles un déphasage global $\Delta\Phi$. En effet pour chaque onde l'établissement du champ magnétique parallèle à la direction de propagation avance la vibration circulaire dans le même sens que le courant magnétisant et retarde d'une quantité égale la vibration circulaire en sens contraire. Même si l'état de polarisation de l'onde lumineuse varie au cours de sa propagation le long de la fibre, les effets d'avance et de retard se cumulent le long de cette fibre et les deux ondes émergentes présentent un déphasage susceptible d'être détecté par interférométrie représentant directement les effets induits par le courant I circulant dans le conducteur, les autres effets étant subis de manière identique par les deux ondes et n'introduisant donc pas entre elles de déphasage.

Le dispositif de mesure représenté fournit sur le détecteur une intensité lumineuse L qui varie en fonction du déphasage $\Delta\Phi$ entre les deux ondes contrarotatives suivant la courbe représentée sur la figure 2, le déphasage $\Delta\Phi$ étant fonction du courant I circulant dans le conducteur. Mais, du fait des variations subies par les ondes dans la fibre en fonction du temps, le facteur d'échelle de cette courbe n'est pas fixe dans le temps, c'est-à-dire que l'intensité lumineuse $L_1$ détectée pour un déphasage induit $\Delta\Phi_1$ fixé, dû à un courant donné $I_1$ peut varier en fonction du temps. Ce dispositif de mesure ne permet donc pas de fournir une mesure absolue du courant I.

Le dispositif de mesure représenté sur la figure 3 met en œuvre une méthode de zéro permettant à chaque instant de disposer d'une valeur de référence i ajustée pour produire un déphasage entre les deux ondes contrarotatives par effet Faraday compensant exactement le déphasage induit par le courant I à mesurer, ce courant i étant alors directement proportionnel au courant I à mesurer. Le dispositif de mesure représenté sur cette figure comporte, comme celui représenté sur la figure 1, une fibre optique 1 comportant M spires enroulées autour du conducteur 2 dans lequel circule le courant I à mesurer. Cette fibre est alimentée par deux ondes optiques de la même façon que celle représentée sur la figure 1. Le dispositif comporte en outre un conducteur 8 comportant m spires entourant une (ou plusieurs) spire de la fibre optique enroulée 1. Ce conducteur 8 est parcouru par un courant variable i délivré par un générateur de courant 9. Le signal issu du photodétecteur 7 correspondant aux interférences entre les deux ondes contrarotatives émergeant de la fibre, est transmis à un dispositif de traitement 10 qui fournit au générateur de courant 9 un signal de commande tel qu'à chaque instant le déphasage entre les deux ondes contrarotatives soit nul.

Si K est la constante de Verdet du matériau formant la fibre, M étant le nombre de spires enroulées autour du conducteur 2, N étant le nombre de branches du conducteur entouré par cette fibre enroulée 1, le déphasage $\Delta\Phi_1$ induit par le courant I circulant dans le conducteur 2 est :

$$\Delta\Phi_1 = KMNI.$$

Si n est le nombre de spires du conducteur 8 entourant m spires de la fibre optique 1, le déphasage $\Delta\Phi_2$ induit par le courant i circulant dans le conducteur 8 est :

$$\Delta\Phi_2 = Kmni.$$

Le circuit de traitement 10 applique au générateur de courant un signal de commande tel qu'à chaque instant $\Delta\Phi_1 = -\Delta\Phi_2$, le déphasage entre les deux ondes contrarotatives étant ainsi maintenu égal à zéro à tout moment. La valeur du courant I se déduit alors de la valeur du courant i par la relation $I = mn/MN \cdot i$.

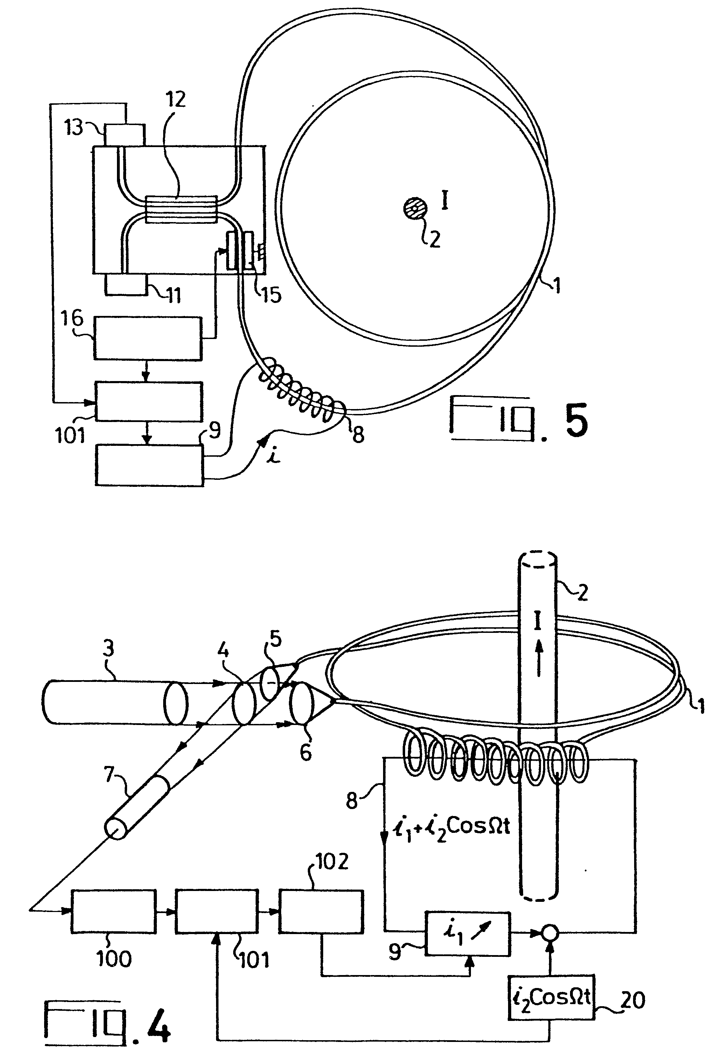

Sur la figure 3, $M = 3$, $N = 1$, $m = 10$ et $n = 3$. Ce dispositif de mesure dans lequel la mesure est effectuée par une méthode de zéro en bande de base, avec un asservissement du courant i permet d'obtenir une mesure avec une résolution de l'ordre de $10^{-3}$ du plein calibre, le courant I ainsi mesurable pouvant varier en fréquence entre le continu et quelques MHz, la limite supérieure de la bande étant déterminée par la limite en fréquence du détecteur. Pour obtenir un dispositif de mesure ayant une résolution plus importante, plusieurs méthodes sont envisageables. La première consiste à moduler le courant circulant dans le conducteur de référence 8 et à effectuer ensuite une détection hétérodyne à la fréquence de modulation de ce courant, le signal issu de cette détection hétérodyne permettant d'asservir la composante continue du courant circulant dans le conducteur 8. La figure 4 représente un tel mode de réalisation. Le système optique n'est pas modifié par rapport à celui représenté sur la figure 3, par contre la fibre optique a été représentée comme comportant deux spires entourant le conducteur dans lequel circule le courant I, l'une de ces spires étant elle-même enroulée autour du conducteur 8. Le courant circulant dans ce conducteur comporte une composante continue $i_1$ et une composante alternative $i_2\cos\Omega t$ fournie par un générateur de courant alternatif 20. Le déphasage entre les deux ondes contrarotatives circulant dans la fibre a donc, dans ces conditions, une composante continue et une composante variant à la pulsation $\Omega$. Le phorodétecteur 7 délivre donc une intensité lumineuse variant à la pulsation $\Omega$. Le signal issu du photodétecteur 7 est appliqué à un circuit amplificateur 100, le signal de sortie de cet amplificateur étant appliqué à un détecteur hétérodyne 101 recevant par ailleurs un signal synchrone du signal de modulation fourni par le générateur 20. Ce détecteur 101 fournit à un circuit amplificateur 102 un signal permettant d'asservir la composante continue du courant $i_1$ de façon que le déphasage entre les deux ondes contrarotatives mis en évidence par les interférences détectées par le photodétecteur ait une composante continue nulle. La plage de mesure de ce dispositif est considérablement supérieure à celle du dispositif décrit en référence à la figure 3. La précision peut être $10^{-5}$ fois la valeur la plus grande mesurable. La bande passante d'un tel dispositif est comprise entre le courant continu et des courants alternatifs à quelques kHz, cette limitation étant imposée par la bobine de courant 8. Dans ce dispositif, la valeur du courant I se déduit directement de la valeur du courant $i_1$ asservi.

Le dispositif optique comportant les moyens de séparation et de recombinaison peut être réalisé sur un circuit optique intégré auquel sont couplés la source de lumière, les deux extrémités de la fibre et le dispositif de détection.

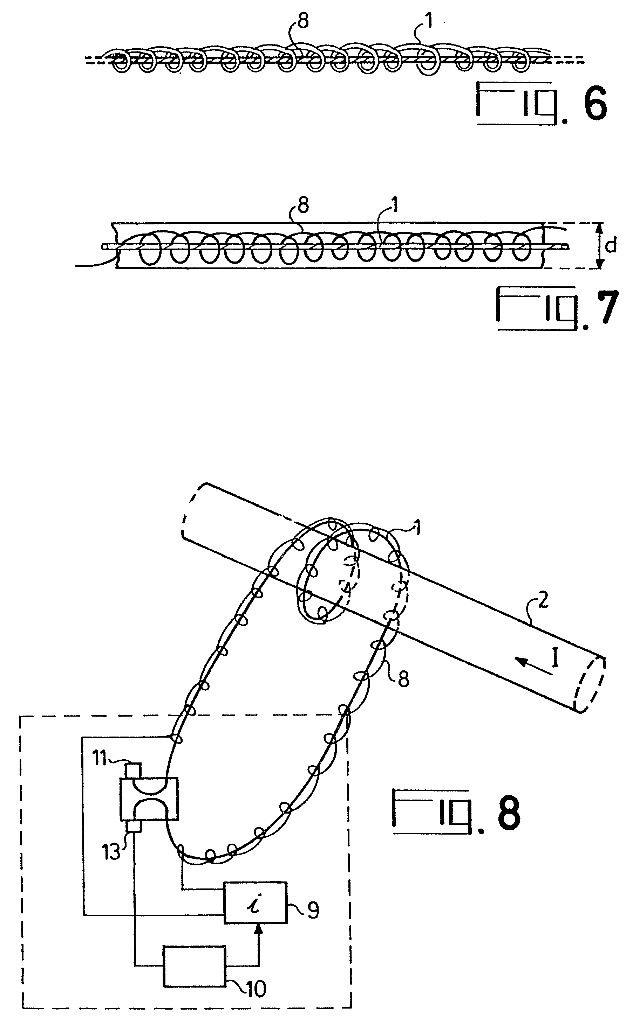

La figure 5 représente un autre mode de réalisation du dispositif de mesure de courant suivant l'invention. Ce dispositif comporte pour la partie optique un circuit optique intégré alimenté par une source laser à semi-conducteur 11 directement couplée par la tranche à la plaquette de circuit intégré. Un coupleur à 3 dB, 12, permet de séparer le faisceau lumineux issu de la source laser 11 entre deux branches de guide optique intégré, ces deux branches étant respectivement couplées aux deux extrémités de la fibre optique enroulée 1. Le dispositif comporte en outre pour la détection des ondes émergeant après circulation en sens contraires un détecteur 13 détectant le rayonnement résultant de la superposition des deux ondes par le coupleur 12. Le signal de sortie de ce détecteur est appliqué comme précédemment à un dispositif de traitement 101 fournissant au générateur de courant 9 un signal de commande permettant de faire varier le courant i circulant dans le conducteur 8 entourant la fibre optique. Dans le but d'augmenter la résolution du dispositif de mesure, il est possible, au lieu de moduler le courant i circulant dans le conducteur de référence, de moduler la phase de l'onde optique. Pour cela, la structure optique intégrée est particulièrement adaptée car il est possible de réaliser de manière simple un modulateur de phase placé dans le circuit optique intégré sur l'un des deux guides d'onde disposés à la sortie du coupleur 3 dB. Ce modulateur de phase 15 a été représenté schématiquement sur la figure 5. Comme précédemment mais pour des raisons différentes, le déphasage entre les deux ondes émergeant des deux extrémités de la fibre est modulé à la pulsation $\Omega$ au moyen d'un générateur de signal de modulation 16. Le circuit de traitement comprendra donc dans un tel cas un détecteur hétérodyne 101 recevant un signal de référence à la fréquence $\Omega$ et fournissant le générateur de courant 9 un signal de commande. Ce dispositif de mesure, lorsque la phase est modulée, permet d'obtenir une bande passante un peu plus grande que celle susceptible d'être obtenue lorsque le courant i est directement modulé. Cette bande passante peut s'étendre jusqu'à quelques MHz. Il serait également possible pour la détection de mettre en œuvre une détection par modulation réciproque, en utilisant le même modulateur de phase électrooptique intégré commandé par un signal de modulation de période égale à 2 fois le temps de parcours de la fibre par l'onde optique. En effet, lorsque la différence de phase entre les deux ondes contrarotatives dû à l'effet Faraday est nulle, et que seule existe une différence de phase due à la modulation, le signal détecté comporte une composante à la fréquence double de la fréquence de modulation. La détection de cette composante à fréquence double qui existe seulement lorsque $\Delta\Phi = 0$ permet donc de déterminer sans ambiguïté la valeur du courant i de référence pour laquelle l'effet Faraday induit par le courant I est exactement compensé. Dans un dispositif à éléments discrets il est également possible de moduler la phase de l'onde se propageant dans la boucle de fibre de manière réciproque. Pour cela un modulateur de phase, qui peut être réalisé en enroulant quelques spires de fibre autour d'une céramique piézoélectrique, dont la période de modulation est égale à deux fois le temps de parcours dans la boucle de fibre permet d'obtenir par détection de la composante à fréquence double le courant i annulant l'effet Faraday.

Dans les dispositifs de mesure de courant utilisant une méthode de zéro, la description ci-dessus montre que le capteur est principalement constitué d'une fibre optique et d'un conducteur convenablement disposés l'un par rapport à l'autre de façon que lorsque la fibre optique entoure le conducteur principal dans lequel circule le courant I à mesurer, le conducteur 8 induise dans la même fibre optique une variation de phase qui compense exactement celle qui est induite par le courant I. Cet élément capteur constitué à la fois d'une fibre optique et d'un conducteur peut être réalisé de manière simple. Deux modes de réalisation sont représentés respectivement sur les figures 6 et 7. Le mode de réalisation de l'élément capteur représenté sur la figure 6 comporte une âme métallique formant le conducteur 8 entourée d'une fibre optique enroulée. Cet élément peut être disponible dans de grandes longueurs, le rapport de transformation déterminé par le nombre de spires de fibre entourant une longueur donnée du câble métallique étant déterminé à l'avance. Suivant la gamme de courant I à mesurer, le conducteur 2 dans lequel circule ce courant I sera entouré d'une ou plusieurs spires du composant capteur formé de la fibre 1 et de l'âme métallique formant conducteur 8.

Un mode de réalisation équivalent est représenté sur la figure 7, dans ce cas, l'âme de l'élément capteur est formée par la fibre optique 1, le conducteur 8 entourant cette fibre optique. Le diamètre de cet élément capteur peut être de l'ordre de 1 mm. Comme précédemment, en fonction de la gamme de courant à mesurer, cet élément capteur entourera le conducteur 2 en formant une ou plusieurs spires, le rapport de transformation étant prédéterminé du fait du nombre de spires du conducteur 8 par unité de longueur de la fibre optique 1. La figure 8 indique schématiquement comment il est possible, dans une implantation, de dissocier la partie capteur et la partie mesure du dispositif de mesure de courant, la partie capteur servant également de liaison entre le conducteur 2 et la partie mesure du dispositif. Sur cette figure, la disposition relative de la fibre et du conducteur représenté sur la figure 7 a été reprise, mais cette disposition n'est pas limitative. La distance séparant le conducteur 2 dans lequel circule le courant I à mesurer et la partie mesure du dispositif peut être de plusieurs mètres ce qui permet d'éloigner cette partie mesure d'un environnement dans lequel les conditions peuvent être très difficiles.

Le dispositif de mesure de courant suivant l'un quelconque des modes de réalisation décrits permet de mesurer des courants de plusieurs centaines de milliers d'ampères, c'est-à-dire les plus grands courants utilisés actuellement, avec une très grande précision. Ce dispositif peut également permettre la mesure de petits courants, de l'ordre du mA.

L'invention n'est pas limitée aux modes de réalisation précisemment décrits et représentés. En particulier, la fibre optique 1 dans laquelle circule les deux ondes contrarotatives et les conducteurs 2 et 8 dans lesquels circulent respectivement le courant I à mesurer et le courant de référence i, peuvent être disposés de toutes façons convenable. Il est également possible avec ce dispositif de mesurer la densité de courant dans une cuve électrolytique en plongeant une boucle de fibre dans la cuve ; la surface de cette boucle étant connue, la densité de courant intégrée sur cette surface est égale à la circulation du champ magnétique induit par le courant autour de cette surface. Ce champ magnétique induit de la même façon que précédemment un déphasage entre les deux ondes circulant en sens contraires dans la fibre par effet Faraday.

De plus, il est également possible de mesurer un déséquilibre de courant entre les différents conducteurs d'une ligne polyphasée, la fibre optique entourant dans ce cas plusieurs conducteurs dans lesquels circulent des courants différents.

Enfin, les circuits de traitement de signaux ont été décrits et représentés schématiquement ; ils peuvent être complétés, si il y a lieu pour obtenir une mesure avec une meilleure précision.

**Revendications**

1. Dispositif interférométrique de mesure de courant électrique à fibre optique caractérisé en ce qu'il comporte une fibre optique (1) enroulée formant au moins une spire autour d'un conducteur (2) dans lequel circule le courant I à mesurer, et en ce que les deux extrémités de cette fibre optique sont couplées à une source de lumière (3, 11) par un dispositif optique comportant des moyens (4, 12) de séparation du faisceau issu de la source en deux ondes destinées à circuler dans la fibre en sens contraires, le dispositif optique comportant également des moyens (4, 12) de recombinaison des ondes émergeant de la fibre et un dispositif de détection (7, 13) fournissant un signal correspondant aux interférences entre les deux ondes émergeant de la fibre, le signal issu du dispositif de détection étant lié au déphasage $\Delta\Phi_1$ entre les deux ondes circulant en sens contraires, ce déphasage étant induit par le courant I par effet Faraday dans la fibre, le dispositif de mesure comportant en outre un dispositif de traitement de signal (10, 101, 102) couplé au dispositif de détection (7, 13) et fournissant à partir du signal issu du dispositif de détection, un signal lié au déphasage $\Delta\Phi_1$.

2. Dispositif selon la revendication 1, caractérisé en ce qu'il comporte en outre un circuit conducteur de référence (8) disposé à proximité de la fibre optique, ce circuit conducteur étant alimenté par un générateur de courant de référence (9) réglable (i), pour induire par effet Faraday dû au courant i de référence, un déphasage entre les deux ondes $\Delta\Phi_2$, le signal fourni par le dispositif de traitement (10, 101, 102) commandant le générateur réglable de manière à ce que le courant i maintienne à zéro le déphasage $\Delta\Phi$ entre les deux ondes résultant de la superposition des déphasages $\Delta\Phi_1$ et $\Delta\Phi_2$.

3. Dispositif selon la revendication 2, caractérisé en ce que le circuit conducteur de référence (8) forme plusieurs spires autour d'au moins une partie de la fibre optique (1).

4. Dispositif selon la revendication 2, caractérisé en ce que la fibre optique (1) forme plusieurs spires autour d'au moins une partie du circuit conducteur de référence (8).

5. Dispositif selon l'une quelconque des revendications précédentes, caractérisé en ce que le dispositif optique comportant les moyens de séparation et de recombinaison (4, 12) est réalisé sur un circuit optique intégré auquel sont couplés la source de lumière (3, 11), les deux extrémités de la fibre (1) et le dispositif de détection (7, 13).

6. Dispositif selon l'une quelconque des revendications 2 à 5, caractérisé en ce que le circuit conducteur de référence (8) est alimenté par un générateur de courant alternatif (20) ajoutant au courant de référence réglable une composante alternative, le dispositif de traitement comportant un détecteur hétérodyne (101) destiné à recevoir un signal issu du dispositif de détection (7) et un signal synchrone de la composante alternative, le signal de sortie de ce détecteur hétérodyne fournissant le signal de commande au générateur de courant de référence réglable (9).

7. Dispositif selon l'une quelconque des revendications 2 à 5, caractérisé en ce qu'il comporte en outre un modulateur de phase (15) agissant sur la phase des ondes optiques circulant dans la fibre (1) pour moduler cette phase à une fréquence donnée, le dispositif de traitement comportant un détecteur hétérodyne (101) destiné à recevoir le signal issu du dispositif de détection (7) et un signal synchrone du signal de commande du modulateur de phase (15), le signal de sortie de ce détecteur hétérodyne étant le signal de commande du générateur de courant de référence (9).

8. Dispositif selon l'une quelconque des revendications 2 à 5, caractérisé en ce qu'il comporte en outre un modulateur de phase (15) agissant sur les ondes optiques, commandé par un signal de modulation de période double du temps de parcours de la lumière dans la fibre enroulée, le dispositif de traitement (10) comportant un dispositif de détection de signal à la fréquence double du signal de modulation délivrant un signal de sortie lorsque le déphasage $\Delta\Phi$ est nul.

9. Dispositif selon l'une des revendications 7 et 8, caractérisé en ce que, le dispositif optique étant réalisé en optique intégrée, le modulateur de phase (15) est réalisé en optique intégrée sur le même circuit.

10. Dispositif selon l'une des revendications 7 et 8, caractérisé en ce que le modulateur de phase (15) comporte une céramique piézoélectrique autour de laquelle est enroulée une longueur donnée de la fibre optique.

## Claims

1. Interferometer device for measuring an electric current comprising an optical fiber, characterized in that the optical fiber (1) is wound around a conductor (2) by forming at least one winding, in which conductor the current I to be measured flows, that the two ends of the optical fiber are coupled to a light source (3, 11) by means of an optical device, that the optical device contains means (4, 12) for separating the beam which issues from the source into two waves for circulating in the fiber in opposite sense, that the optical device further contains means (4, 12) for recombining the waves issuing from the fiber, that the optical device further contains detectors means (7, 13) furnishing a signal which represents the interferences between the waves leaving the two fibers, that the signal leaving the detector means is related to the phase shift $\Delta\Phi_1$ between the two waves circulating in opposite sense, this phase shift being caused by the current I due to the Faraday effect in the fiber, and that a signal processing means (10, 101, 102) is provided which is coupled to the detector means (7, 13) and generates from the signal leaving the detector means a signal related to the phase shift $\Delta\Phi_1$.

2. Device according to claim 1, characterized in that in proximity to the optical fiber a reference conductor circuit (8) is provided which is fed by an adjustable reference current generator (9 ; i) and through which by means of the reference current i due to the Faraday effect a phase shift $\Delta\Phi_2$ between the two waves is generated, the signal furnished from the signal processing means (10, 101, 102) controlling the adjustable reference current generator in such a manner that the current i maintains the phase shift $\Delta\Phi$ resulting from the superposition of the phase shift $\Delta\Phi_1$ and $\Delta\Phi_2$ between the two waves on the value zero.

3. Device according to claim 2, characterized in that the reference conductor circuit (8) forms several windings around at least a part of the optical fiber (1).

4. Device according to claim 2, characterized in that the optical fiber (1) forms several windings around at least a part of the reference conductor circuit (8).

5. Device according to any one of the preceding claims, characterized in that the optical device containing the means (4, 12) for separating and for recombining is formed by an integrated optical circuit to which the light source (3, 11), both ends of the fiber (1) and the detector means (7) are coupled.

6. Device according to any one of claims 2 to 5, characterized in that the reference conductor circuit (8) is fed by an alternative current generator (20) adding to the adjustable reference current an alternating current component, and that the signal processing means contains a heterodyne detector (101) receiving a signal furnished by the detector means (7) and a signal synchronous to the alternative current component, the output signal of said heterodyne detector furnishing the control signal to the adjustable reference current generator (9).

7. Device according to any one of claims 2 to 5, characterized in that a phase modulator (15) is provided acting on the phases of the optical waves circulating in the fiber (1) in such a manner that they are modulated with a given frequency, and that the signal processing means contains a heterodyne detector (101) receiving the signal furnished by the detector means (7) and a signal synchronous to the control signal of the phase modulator (15), the output signal of said heterodyne detector being the control signal of the reference current generator (9).

8. Device according to any one of claims 2 to 5, characterized in that a phase modulator (15) is provided acting upon the optical waves, said phase modulator being controlled by a modulation signal the period of which corresponds to twice the propagation time of the light in the wound-up fiber, and that for the signal processing means (10) a detector means is provided detecting a signal the frequency of which is twice the frequency of the modulation signal, said detection means furnishing an output signal whenever the phase shift $\Delta\Phi$ has the value zero.

9. Device according to claim 7 or 8, characterized in that the optical device is manufactured as an integrated optical structure and that the phase modulator (15) is manufactured on the same circuit as an integrated optical structure.

10. Device according to claim 7 or 8, characterized in that the phase modulator (15) contains a piezoelectric ceramic around which a given length of the optical fiber is wound.

## Ansprüche

1. Interferometervorrichtung zum Messen eines elektrischen Stroms mit einer optischen Faser, dadurch gekennzeichnet, daß die optische Faser (1) unter Bildung wenigstens einer Windung um einen Leiter (2) gewickelt ist, in dem der fließende Strom I gemessen werden soll, daß die zwei Enden dieser optischen Faser mittels einer optischen Vorrichtung an eine Lichtquelle (3, 11) angekoppelt sind, daß die optische Vorrichtung Mittel (4, 12) zum Aufteilen des die Quelle verlassenden Strahls in zwei Wellen enthält, die dazu bestimmt sind, die Faser gegensinnig zu durchlaufen, daß die optische Vorrichtung außerdem Mittel (4, 12) zum Rekombinieren der die Faser verlassenden Wellen enthält, daß die optische Vorrichtung ferner eine Detektionsvorrichtung (7, 13) enthält, die ein den Interferenzen zwischen den zwei die Faser verlassenden Wellen entsprechendes Signal abgibt, daß das die Detektionsvorrichtung verlassende Signal mit der Phasenverschiebung $\Delta\Phi_1$ zwischen den zwei gegensinnig umlaufenden Wellen in Beziehung steht, wobei diese Phasenverschiebung durch den Strom I aufgrund des Faraday-Effekts in der Faser hervorgerufen wird, und daß ferner eine Signalverarbeitungsvorrichtung (10, 101, 102) vorgesehen ist, die an die Detektionsvorrichtung (7, 13) angekoppelt ist und aus dem die Detektionsvorrichtung verlassenden Signal ein mit der Phasenverschiebung $\Delta\Phi_1$ in Beziehung stehendes Signal erzeugt.

2. Vorrichtung nach Anspruch 1, dadurch gekennzeichnet, daß in der Nähe der optischen Faser ein Bezugsleiterkreis (8) angeordnet ist, der von einem einstellbaren Bezugsstromgenerator (9 ; i) gespeist ist und durch den vom Bezugsstrom i mittels des Faraday-Effekts eine Phasenverschiebung $\Delta\Phi_2$ zwischen den zwei Wellen erzeugt wird, wobei das von der Signalverarbeitungsvorrichtung (10, 101, 102) gelieferte Signal den einstellbaren Bezugsstromgenerator so steuert, daß der Strom i die aus der Überlagerung der Phasenverschiebungen $\Delta\Phi_1$ und $\Delta\Phi_2$ resultierende Phasenverschiebung $\Delta\Phi$ zwischen den zwei Wellen auf Null hält.

3. Vorrichtung nach Anspruch 2, dadurch gekennzeichnet, daß der Bezugsleiterkreis (8) mehrere Windungen um wenigstens einen Teil der optischen Faser (1) bildet.

4. Vorrichtung nach Anspruch 2, dadurch gekennzeichnet, daß die optische Faser (1) mehrere Windungen um wenigstens einen Teil des Bezugsleiterkreises (8) bildet.

5. Vorrichtung nach einem der vorhergehenden Ansprüche, dadurch gekennzeichnet, daß die optische Vorrichtung, die die Mittel (4, 12) zum Aufteilen und zum Rekombinieren enthält, von einer integrierten optischen Schaltung gebildet ist, an die die Lichtquelle (3, 11), die zwei Enden der Faser (1) und die Detektionsvorrichtung (7, 13) angekoppelt sind.

6. Vorrichtung nach einem der Ansprüche 2 bis 5, dadurch gekennzeichnet, daß der Bezugsleiterkreis (8) von einem Wechselstromgenerator (20) gespeist wird, der dem einstellbaren Bezugsstrom eine Wechselkomponente hinzufügt, und daß die Signalverarbeitungsvorrichtung einen Überlagerungsdetektor (101) enthält, der ein von der Detektionsvorrichtung (7) abgegebenes Signal sowie ein zur Wechselkomponente synchrones Signal empfängt, wobei das Ausgangssignal dieses Überlagerungsdetektors das Steuersignal an den einstellbaren Bezugsstromgenerator (9) liefert.

7. Vorrichtung nach einem der Ansprüche 2 bis 5, dadurch gekennzeichnet, daß ein Phasenmodulator (15) vorgesehen ist, der so auf die Phase der in der Faser (1) umlaufenden optischen Wellen einwirkt, daß sie mit einer gegebenen Frequenz moduliert wird, und daß die Signalverarbeitungsvorrichtung einen Überlagerungsdetektor (101) enthält, der das von der Detektionsvorrichtung (7) abgegebene Signal und ein zum Steuersignal des Phasenmodulators (15) synchrones Signal empfängt, wobei das Ausgangssignal dieses Überlagerungsdetektors das Steuersignal des Bezugsstromgenerators (9) ist.

8. Vorrichtung nach einem der Ansprüche 2 bis 5, dadurch gekennzeichnet, daß ein auf die optischen Wellen einwirkender Phasenmodulator (15) vorgesehen ist, der von einem Modulationssignal gesteuert wird, dessen Periode der doppelten Laufzeit des Lichts in der aufgewickelten Faser entspricht, und daß für die Signalverarbeitungsvorrichtung (10) eine Detektionsvorrichtung vorgesehen ist, die ein Signal mit der Frequenz erfaßt, die doppelt so groß wie die Frequenz des Modulationssignals ist, wobei diese Detektionsvorrichtung ein Ausgangssignal abgibt, wenn die Phasenverschiebung $\Delta\Phi$ den Wert Null hat.

9. Vorrichtung nach Anspruch 7 oder 8, dadurch gekennzeichnet, daß die optische Vorrichtung als integrierte optische Struktur hergestellt ist und daß der Phasenmodulator (15) auf der gleichen Schaltung als integrierte optische Struktur hergestellt ist.

10. Vorrichtung nach Anspruch 7 oder 8, dadurch gekennzeichnet, daß der Phasenmodulator (15) eine piezoelektrische Keramik enthält, um die ein gegebenes Längestück der optischen Faser gewickelt ist.

0 023 180

Fig.1

Fig.2

Fig.3

Fig. 5

Fig. 4

Fig. 6

Fig. 7

Fig. 8

3